# EUROPÄISCHE PATENTANMELDUNG

(11) **EP 4 831 658 A1**
(43) Veröffentlichungstag der Anmeldung: **28.10.2026**
(21) Anmeldenummer: 25172368.0
(22) Anmeldetag: 24.04.2025
(51) Int. Cl.: G01R 31/28

(54) **VERFAHREN ZUR ÜBERWACHUNG EINER ELEKTRISCHEN BAUGRUPPE MIT EINEM TEMPERATURSENSOR**

(71) Anmelder: Siemens Aktiengesellschaft, 80333 München (DE)
(72) Erfinder: Frühauf, Peter, 14612 Falkensee (DE); Jeske, Nora, 10555 Berlin (DE); Müller, Bernd, 16259 Falkenberg (DE)
(74) Vertreter: Siemens Patent Attorneys

(57) **Zusammenfassung**

Die Erfindung betrifft ein Verfahren zur Überwachung einer elektronischen Baugruppe (2) mit einem Temperatursensor (4), umfassend folgende Schritte:
- Unterziehen mindestens einer Referenzbaugruppe (6) einer zyklischen Temperaturbehandlung (8), wobei Referenz-Belastungswerte (10) an Hand der Anzahl der Temperaturzyklen (12) und der Temperaturunterschiede (14) pro Temperaturzyklus bestimmt werden und hieraus ein Lebensdauererwartungswert (16) ermittelt wird,
- Messen von Feld-Belastungswerten (18) von im Einsatz befindlichen Feldbaugruppen (20),
- Übermitteln der Feld-Belastungswerte (18) über eine Datenverbindung (22) an eine von der Feldbaugruppe (20) räumlich getrennten elektronischen Auswerteeinheit (24),
- Ermitteln mittels eines Raffungsmodells eines kumulativer Belastungswertes (26),
- Ermitteln einer Maßnahme (28) durch die Auswerteeinheit (24) anhand eines Maßnahmenkatalogs (30) durch den Vergleich von Lebensdauererwartungswert (16) und kumulativer Belastungswert (26),
- Übermitteln der Maßnahme (28) über eine zweite Datenverbindung (23) an eine Überwachungseinheit (32) der Feldbaugruppen (20).

## Beschreibung

Die Erfindung betrifft ein Verfahren zur Überwachung einer elektronischen Baugruppe mit einem Temperatursensor nach Patentanspruch 1.

Aufgrund von Bauelementeknappheit und einem verstärkten Bestreben Produkte einem sogenannten Closed-Loop-System zuzuführen und die Nachhaltigkeit der Produkte zu höhen, werden Bewertungsmethoden für die Einschätzung der Restlebensdauer von Komponenten und Modulen immer wichtiger. Insbesondere die schnelle Messung und Auswertung von Umweltbelastungen während des Einsatzes der Geräte ist dabei von Bedeutung. Grundsätzlich ist es wichtig die Restlebensdauer eines Bauelementes einschätzen zu können, da ein unerwarteter Ausfall während des Betriebs Schäden im gesteuerten Prozess hervorgerufen kann, andererseits ist auch eine Wiederverwertbarkeit der elektronischen Baugruppe beispielsweise durch Reparieren oder durch eine Wiederverwendung und ein sogenanntes Refurbishing von Bedeutung.

Bisher kann die Restlebensdauer von Komponenten wie elektronischen Baugruppen oder einem ganzen Produkt nach einem Feldrücklauf nur eingeschränkt, bis gar nicht definiert werden. Zumeist wird das gesamte Produkt bzw. die gesamte Elektronik unabhängig von ihrem Einsatz und den durchlaufenen Umweltbedingungen entsorgt und gegebenenfalls einem Recyclingprozess durch Rückgewinnung von der Materialien zugeführt. Eine Wiederverwertung bzw. die Wiederverwendung (pre-used) von einzelnen Komponenten oder ganzen Systemen, die weiterhin funktionsfähig sind, wird aus Kostengründen und aufgrund fehlender Bewertungsmethoden zur Bestimmung der Restlebensdauer sowie Feldbedingungen währen dem Einsatz nicht durchgeführt. Hinderlich sind hierbei vor allem fehlende Felddaten, die einen Aufschluss über die Umweltbelastung geben, denen das Produkt ausgesetzt war sowie fehlende Berechnungs- und Bewertungsgrundlage. Andererseits ist es für den Betreiber einer elektronischen Baugruppe wichtig zu wissen, wie lange diese voraussichtlich noch einsatzbereit sein wird, bzw. wie lange sie noch sicher einsatzbereit ist. Ferner ist auch für den Betreiber ein Wissen über eine mögliche Wiederverwertung eine elektronischen Baugruppe von Bedeutung.

Der Erfindung liegt somit die Aufgabe zugrunde, ein Verfahren zur Überwachung einer elektronischen Baugruppe bereitzustellen, das gegenüber dem Stand der Technik eine höhere Prozesssicherheit und eine bessere Abschätzung über Wiederverwertbarkeit von elektronischen Baugruppen aufweist.

Die Lösung der Aufgabe besteht in einem Verfahren zur Überwachung einer elektronischen Baugruppe mit den Merkmalen des Patentanspruchs 1.

Das Verfahren zur Überwachung einer elektronischen Baugruppe bedient sich hierbei eines Temperatursensors und umfasst dabei folgende Schritte:
- Unterziehen mindestens einer Referenzbaugruppe einer zyklischen Temperaturbehandlung, wobei Referenzbelastungswerte anhand der Anzahl der Temperaturzyklen und der Temperaturunterschiede pro Temperaturzyklus bestimmt werden und hieraus ein Lebensdauererwartungswert ermittelt wird.
- Messen von Feld-Belastungswerten von im Einsatz befindlichen Baugruppen,
- Übermitteln der Feldbelastungswerte über eine Datenverbindung an eine elektronische Auswerteeinheit,
- Ermitteln mittels eines Raffungsmodells eines kumulativen Belastungswertes,
- Ermitteln einer Maßnahme durch die Auswerteeinheit anhand eines Maßnahmenkatalogs durch den Vergleich von Lebensdauererwartungswerten und kumulativen Belastungswertes,
- Übermitteln der Maßnahmen über eine zweite Datenverbindung an eine Überwachungseinheit der Feldbaugruppe.

Die elektronische Auswerteeinheit ist bevorzugt von der Feldbaugruppe räumlich getrennt angeordnet, sodass für eine Vielzahl von Feldbaugruppen in einer zentralen Auswerteeinheit die Daten einer Vielzahl von Feldbaugruppen ausgewertet werden können. Dies ermöglicht es, in der zentralen Auswerteeinheit die Informationen zum Alterungsprozess im realen Feld zu aktualisieren und noch weiter zu verbessern.

Dabei seien im Folgenden die hier verwendeten Begriffe definiert: Die Temperatursensoren, wie beispielsweise ein Digital Thermal Sensor (DTS), messen die Temperatur durch die Änderung elektrischer Eigenschaften wie z. B. dem Widerstand oder der Spannung. Diese Eigenschaften ändern sich sowohl durch die Temperatur der CPU (Central Processing Unit) selbst als auch durch die Umgebungstemperatur. Die Sensoren können schnelle Temperaturänderungen in Echtzeit erfassen. Die CPU nutzt diese Temperaturdaten, um die Lüftergeschwindigkeit anzupassen und gegebenenfalls die Leistung zu drosseln, um eine Überhitzung zu verhindern. Durch die Kombination von Echtzeitüberwachung und kontinuierlicher Datenerfassung können die Temperatursensoren der CPU eine zuverlässige Methode zur Erkennung und Analyse von Temperaturüberschreitungen bieten. Die meisten Temperatursensoren in CPUs arbeiten auf Basis von Halbleitertechnologien. Sie messen die Temperaturen durch die Änderung elektrischer Eigenschaften, wie z. B. dem Widerstand oder die Spannung, die sich mit der Temperatur ändern. Da die Sensoren in der Regel direkt auf den Chip der CPU platziert sind, können sie die Temperatur der CPU sehr genau messen. Grundsätzlich ist es jedoch auch möglich, ein normales Thermoelement innerhalb der elektronischen Baugruppe einzubauen und hierüber die Temperaturmessungen vorzunehmen. Da aber bestimmte Bereiche auf dem Chip der CPU ohnehin für die Messung von Temperaturen ausgestaltet sind, ist es zweckmäßig diese für die Temperaturmessung als Temperatursensor zu verwenden.

Eine Referenzbaugruppe ist eine Baugruppe, die entweder baugleich oder bauähnlich einer elektronischen Baugruppe, die im Feld eingesetzt wird, also einer Feldbaugruppe, ist. Diese Referenzbaugruppe wird in einem definierten Alterungsprozess einer zyklischen Temperaturbehandlung unterzogen, wobei Referenzbelastungswerte ermittelt werden. Die Referenzbelastungswerte sind zum einen die Anzahl der Temperaturzyklen und zum anderen die Temperaturunterschiede pro Temperaturzyklus. In einer vorteilhaften Ausgestaltungsform kann als Referenzbelastungswert auch noch die Maximaltemperatur des jeweiligen Temperaturzyklus hinzugezogen werden. Aus dieser künstlichen Alterung der Referenzbaugruppe kann bei Aufnahme der genannten Belastungswerte und deren Auswertung mittels eines mathematischen Modells ein Lebensdauererwartungswert ermittelt werden. Dies kann insbesondere dann besonders gut geschehen, wenn eine Mehrzahl von Referenzbaugruppen der künstlichen Alterung unterzogen werden, und mindestens so lange der künstlichen Temperaturbelastung ausgesetzt werden, bis eine Referenzbaugruppe ausfällt.

Die Feldbelastungswerte von Feldbaugruppen sind grundsätzlich die gleichen Belastungswerte wie die der Referenzbaugruppe, sie gehorchen jedoch der realen Belastung einer Feldbaugruppe und nicht den normierten Standards eines künstlichen Alterungsprozesses bei der Anwendung auf die Referenzbaugruppe. Die Feldbaugruppe ist somit eine Baugruppe, die im aktiven Einsatz im Feld verbaut ist.

Die Auswerteeinheit ist in der Regel eine Recheneinheit, also ein Computer, der von der Feldbaugruppe örtlich getrennt ist, und an die die Feldbelastungswerte über eine Datenverbindung übertragen werden. Die Auswerteeinheit ist dazu geeignet, dass hierauf ein Computerprogramm läuft, das ein sogenanntes Raffungsmodell rechnerisch abbilden kann, wobei mittels eines Raffungsmodells aus den Referenzbelastungswerten und dem daraus abgebildeten Lebensdauererwartungswert sowie den Feldbelastungswerten ein kumulativer Belastungswert für die Feldbaugruppe ermittelt werden kann. Anhand dieses kumulativen Belastungswertes, der mit dem Lebensdauererwartungswert abgeglichen wird, kann mit Hilfe eines Maßnahmenkataloges, eine
Maßnahme für die Feldbaugruppe zum aktuellen Berechnungszeitpunkt vorgenommen werden. Der Maßnahmenkatalog kann beispielsweise die Maßnahme "die Feldbaugruppe kann weiterbetreiben werden", die Maßnahme "die Feldbaugruppe muss gewartet werden", oder die Maßnahme "die Feldbaugruppe muss ersetzt werden", enthalten. Die so ermittelte Maßnahme kann über eine zweite Datenverbindung an die Überwachungseinheit der Feldbaugruppe (die wiederum örtlich getrennt von der Feldbaugruppe bzw. mehrerer Feldbaugruppen angeordnet ist) übertragen werden.

Die Auswerteeinheit umfasst zudem oder sie steht in Verbindung mit einer Speichereinheit, auf der die entsprechenden Werte nämlich Referenzbelastungswerte, Lebensdauererwartungswert und Feldbelastungswerte gespeichert sind.

Der Vorteil der Erfindung gegenüber dem Stand der Technik besteht darin, dass mittels eines Temperatursensors, der ohnehin in der Feldbaugruppe, insbesondere auf der CPU, verbaut ist, und über eine Datenleitung an die Auswerteeinheit eine Fernüberwachung von Feldbaugruppen vorgenommen werden kann. Ein Ausfall der Feldbaugruppe kann somit sicher vorhergesagt werden und es ist auch möglich, eine Feldbaugruppe rechtzeitig auszubauen, sodass eine Überholung für eine Wiederverwertung technisch noch zweckmäßig ist. Hierzu dient insbesondere ein künstlicher Alterungsprozess unter Verwendung von Referenzbaugruppen, mittels dem ein Lebensdauererwartungswert ermittelt wird.

In einer vorteilhaften Ausgestaltungsform der Erfindung weist der Referenzbelastungswert und auch der Feldbelastungswert neben dem Belastungskriterium der Anzahl der Temperaturzyklen und der Temperaturunterschiede pro Zyklus auch noch die Maximaltemperatur pro Temperaturzyklus auf.

Zur Bestimmung des kumulativen Belastungswertes, der für die Feldbaugruppe ermittelt wird, ist es zweckmäßig, dass jedem einzelnen Feldbelastungswert, also jedem einzelnen Temperaturzyklus anhand seiner Auswirkung auf das Alterungsverhalten der Feldbaugruppe ein Gewichtungsfaktor zugeordnet wird. Der Gewichtungsfaktor ist beispielsweise bei Temperaturzyklen mit hohen Maximaltemperaturen oder hohen Temperaturdifferenzen höher als bei niedrigen Temperaturen und niedrigeren Temperaturdifferenzen. Auch die Dauer eines Belastungszyklus kann sich auf den Gewichtungsfaktor auswirken. Somit wird jeder Feldbelastungswert, also jeder Zyklus mit dem Gewichtungsfaktor versehen und alle Feldbelastungswerte multipliziert mit dem Gewichtungsfaktor werden aufsummiert. Diese Summe ergibt nun den kumulativen Belastungswert, der eine Aussage darüber trifft, wie viel Prozent des Lebensdauererwartungswertes nun bereits für die betrachtete Feldbaugruppe erreicht sind.

Die Berechnung des Gewichtungsfaktors wird üblicherweise mit einem sogenannten Raffungsmodell vorgenommen, dem eine mathematische Formel zugrunde liegt, in der die Daten der thermischen Untersuchung der Referenzbaugruppen, also die Referenzbelastungswerte und die Feldbelastungswerte gleichzeitig eingegeben werden. Als besonders zweckmäßig hat sich hierfür das sogenannte Norris-Landzberg-Modell herausgestellt. Dieses Modell folgt der folgenden Formel: $AF = {\left(\frac{{f}_{o}}{{f}_{t}}\right)}^{1 / 3} {\left(\frac{{ΔT}_{t}}{{ΔT}_{o}}\right)}^{1 , 9} {e}^{1414 \left(1/{T}_{o}-1/{T}_{t}\right)}$

Wobei das Ergebnis der Formel AF der sogenannte Acceleration Factor ist. Dieser Beschleunigungsfaktor entspricht dem, was im Vorangegangenen als Gewichtungsfaktor bezeichnet wird. Dies ist ein Maß dafür, wie stark ein entsprechender Temperaturzyklus zur Schädigung und zur Alterung einer Feldbaugruppe beiträgt. In die Formel gehen weiterhin die Frequenzen f, also die jeweilige Anzahl und Dauer der Temperaturzyklen sowie die Temperaturunterschiede ΔT ein. Wobei der Index t jeweils für die Referenzwerte und der Index o für die Feldbelastungswerte stehen. Das beschriebene Norris-Landzberg-Modell, wird hier rein beispielsweise für ein Raffungsmodell angegeben, auch andere Raffungsmodelle können in zweckmäßiger Weise zu einem nützlichen Ergebnis bezüglich des kumulativen Belastungswertes führen. Dieses und auch andere Raffungsmodelle dienen dazu, sowohl die künstlichen Alterungswerte, also die Referenzbelastungswerte und die Feldbelastungswerte miteinander zu verknüpfen. Hieraus wird der Beschleunigungsfaktor, bzw. wie er hier genannt ist, der Gewichtungsfaktor für jeden einzelnen Belastungswert ermittelt.

In einer weiteren Ausgestaltungsform der Erfindung ist es zweckmäßig, dass neben der Referenzbaugruppe eine sogenannte Neben-Referenzbaugruppe der zyklischen Temperaturbehandlung unterzogen wird und ein Lebensdauererwartungswert der Referenzbaugruppe auf die Neben-Referenzbaugruppe übertragen wird. Dies ist deshalb zweckmäßig, da die Referenzbaugruppe, die eine CPU aufweist, auch einen Temperatursensor beinhaltet. Die meisten Neben-Referenzbaugruppen bzw. Neben-Feldbaugruppen z. B. Stromversorgungsbaugruppen, Kommunikationsmodule oder Input-Output-Module weisen häufig keine eigene CPU auf und sind deshalb auch in der Regel nicht mit einem Temperatursensor ausgestattet. Daher ist es zweckmäßig die durch die Referenzbaugruppe gewonnenen Daten mit den jeweiligem Verhalten der Neben-Referenzbaugruppe zu vergleichen und aus diesen Daten ebenfalls einen Lebensdauererwartungswert für die jeweilige Neben-Feldbaugruppe zu ermitteln. Grundsätzlich ist es dabei zweckmäßig, den Lebensdauererwartungswert der Feldbaugruppe auf den Lebensdauererwartungswert der Neben-Feldbaugruppe zu übertragen und somit mit dem beschriebenen Verfahren ebenfalls eine Aussage bzw. eine Maßnahme für die Neben-Feldbaugruppe zu ermitteln. Eine solche Maßnahme kann, wie bereits erwähnt, der Austausch der Feldbaugruppe bzw. der zugeordneten Neben-Feldbaugruppe sein.

Weitere Ausgestaltungsformen und weitere Merkmale werden anhand der folgenden Figuren näher erläutert. Dabei handelt es sich um stark abstrahierte rein schematische Darstellungen, die keine Einschränkung des Schutzbereichs darstellen.

Dabei zeigen:
- Figur 1: eine schematische Darstellung von Feldbaugruppen, die mit einer Auswerteeinheit in Datenverbindung stehen, die wiederum in Datenverbindung mit einer Überwachungseinheit für Feldbaugruppen steht.
- Figur 2: eine vergrößerte Darstellung einer Feldbaugruppe mit einer Neben-Feldbaugruppe und einer CPU mit Messsensor,
- Figur 3: eine schematische Veranschaulichung der Aufnahme von Feldbelastungswerten und Referenzbelastungswerten und deren Umwandlung zu einem kumulativen Belastungswert.

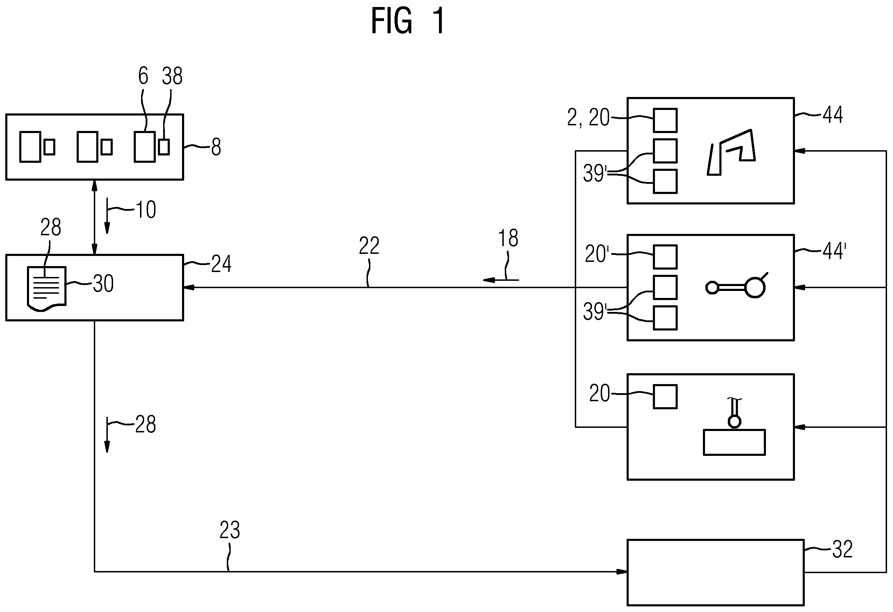

In Figur 1 ist zunächst eine schematische Darstellung des beschriebenen Verfahrens gegeben. Auf der linken Seite ist zunächst ein künstliches Alterungsverhalten in Form einer zyklischen Temperaturbehandlung 8 von Referenzbaugruppen 6 sowie von Neben-Referenzbaugruppen 38 schematisch beschrieben. Auf der rechten Seite sind drei unterschiedliche Anwendungen von Feldanlagen 44, 44', in denen Feldbaugruppen 20 unter Verwendung von fakultativen Neben-Feldbaugruppen 39, 39' beispielsweise zur Steuerung eines industriellen Prozesses eingesetzt sind. Die einzelnen Anwendungen sind hier lediglich piktogrammartig und schematisch dargestellt. Es können industrielle Steuerungen sein, es können Gebäudesteuerungen sein, es können jedoch auch Steuerungen in mobilen Einheiten, wie in Fahrzeugen oder Eisenbahnen, sein, in denen die elektronischen Baugruppen 2 in Form von Feldbaugruppen 20 zum Einsatz kommen.

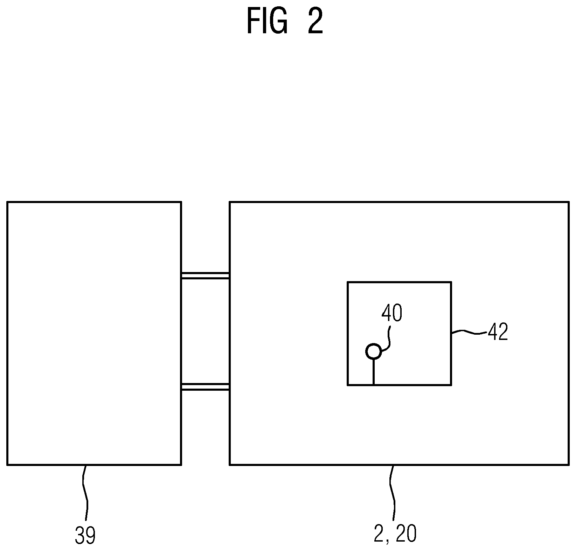

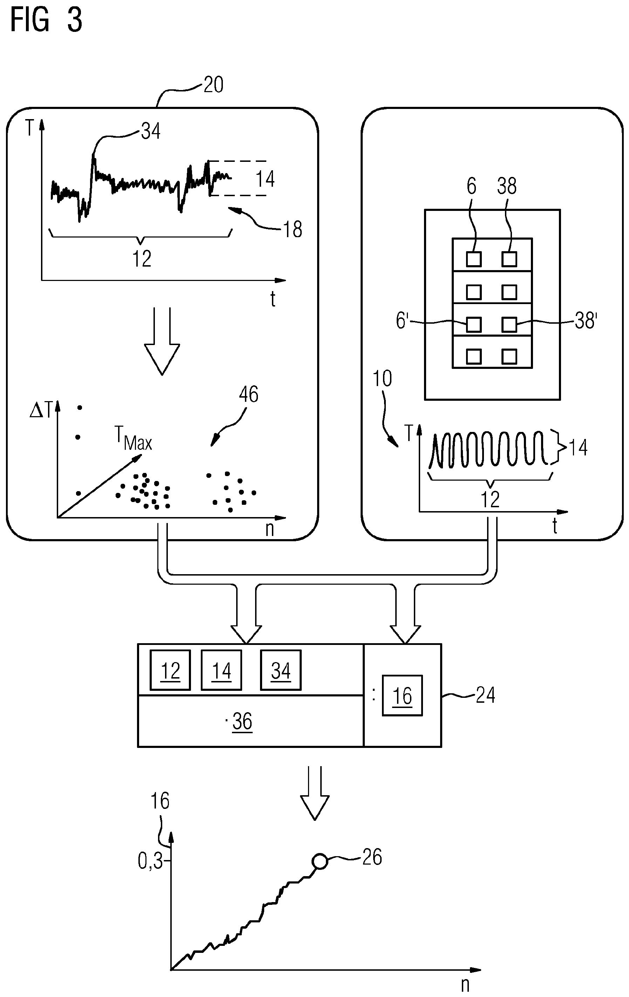

Durch Messsensoren 40 (vergleiche Figur 2) in den Feldbaugruppen 20 werden Temperaturwerte, insbesondere Temperaturzyklen, in Form von Feldbelastungswerten 18 aufgenommen und mittels einer ersten Datenleitung 22 an eine örtlich von den Feldanlagen 44 und Feldbaugruppen 20 getrennten Auswerteeinheit 24 übermittelt. Die Auswerteeinheit 24 wiederum steht in Verbindung mit Referenzbelastungswerten 10, die über zyklische Temperaturbehandlungen 8 der Referenzbaugruppen 6 ermittelt werden. In der Auswerteeinheit 24 ist ferner ein Maßnahmenkatalog 30 mit verschiedenen Maßnahmen 28 hinterlegt. Ferner wird hierauf ein sogenanntes Raffungsmodell als Computerprogramm betrieben, das mittels der Feldbelastungswerten 18 und der Referenzbelastungswerten 10 einen kumulativen Belastungswert ermittelt. Auf dieses Vorgehen wird noch bezüglich Figur 3 näher eingegangen werden.

Der kumulative Belastungswert 26 dient dazu, eine Maßnahme 28 aus dem Maßnahmenkatalog 30 auszuwerten, wobei die Maßnahme 28 an die Überwachungseinheit 32 der Feldbaugruppe 20 übermittelt wird. Eine solche Maßnahme 28 kann beispielsweise zur Auswechslung einer Feldbaugruppe 20 führen. Eine andere Maßnahme 28 kann auch darin bestehen, dass die Feldbaugruppe 20 oder auch die Nebenfeldbaugruppe 39 oder 39' gewartet oder ausgetauscht werden. Gewartete Feldbaugruppen 20 oder Neben-Feldbaugruppen 39 können dann im zweiten Verwendungszweck in einem weiteren Steuerungsprozess oder einer anderen Feldanlage, die hier nicht dargestellt ist, wiederverwendet werden. Dies wäre der Fall, wenn beispielsweise die Feldanlage 44 im beschriebenen Beispiel höchste Anforderungen an die jeweiligen Feldbaugruppen stellt, die mit einer überarbeiteten Feldbaugruppe möglicherweise nicht mehr erfüllt werden könnten. Es kann aber auch dazu dienen, eine Feldbaugruppe auszutauschen und zu recyclen, wenn diese ihr Lebensdauerende erreicht hat. Dies garantiert, dass der Prozess, den die Feldbaugruppe 20 betreut oder steuert, nicht unerwartet unterbrochen wird.

In Figur 2 ist schematisch eine Feldbaugruppe 20 dargestellt, die eine CPU 42 und einen in der CPU 42 integrierten Messsensor 40 aufweist. Mittels diesem Messsensor 40 kann die Temperatur der CPU direkt und intrinsisch gemessen werden. Die Messung erfolgt in der Regel als Widerstandsmessung oder Spannungsmessung auf Bereichen des Chips der CPU, wobei spezielle Halbleiterbereiche dafür ausgestaltet sind diese Messungen vorzunehmen. Der Vorteil zur Verwendung dieses Messsensors 40 direkt auf der CPU besteht darin, dass so sehr verlässliche Werte über die Temperatur bzw. die Temperaturschwankungen, also die Belastungswerte der CPU ermittelt werden können und über die Datenleitung 22 an die Auswerteeinheit 24 übertragen werden können. Ein weiterer Vorteil besteht darin, dass über die Temperaturverhältnisse und die Belastungswerte 18 der Feldbaugruppe auch auf die Belastungswerte 18 einer Neben-Feldbaugruppe 39 geschlossen werden kann. Neben-Feldbaugruppen 39 sind üblicherweise kleinere Baugruppen, die keine eigene CPU mit integriertem Messsensor 40 aufweisen, über die üblicherweise keine Information über ihre Belastungswerte ermittelt werden können. Durch die Übertragung der Belastungswerte 18 und die Lebensdauererwartungswerte 16 der Feldbaugruppe 20 auf die Neben-Feldbaugruppe 39 ist auch eine Aussage über deren weitere Lebenserwartung bzw. ihrem Alterungsstand möglich, was in dem Maßnahmenkatalog 30 der Auswerteeinheit 24 miteinbezogen wird.

In Figur 3 ist schematisch die Bestimmung eines kumulativen Belastungswertes 26 mittels Referenzbelastungswerten 10 und Feldbelastungswerten 18 dargestellt. Zunächst werden Referenzbelastungswerte 10 bei einem definierten Alterungsprozess von Referenzbaugruppen 6 und gegebenenfalls Neben-Referenzbaugruppen 38 vorgenommen. Hierfür gibt es einen definierten Alterungsprozess beispielsweise werden Temperaturzyklen innerhalb von einer Stunde von -40°C auf 125°C durchgeführt. Eine Anzahl n von Temperaturzyklen werden durchfahren, bis eine der Referenzbaugruppen 6 ausfällt. Die zyklische Temperaturbehandlung 8 weist somit eine Anzahl 12 an Temperaturzyklen auf. Dabei handelt es sich um definierte Temperaturunterschiede 14, die, wie bereits beschrieben, in einem Temperaturbereich von beispielsweise -40°C bis 125°C erfolgen.

Im Gegensatz dazu werden die vergleichbare Werte bei Feldbaugruppen 20 aufgenommen, hierbei handelt es sich um die Feldbelastungswerte 18, die den Referenzbelastungswerten 10 zwar grundsätzlich ähneln, aber eben nicht standardisiert sind. Es handelt sich hierbei um Belastungswerte 18, die real beim Betrieb einer Feldbaugruppe auftreten. Hier treten sehr unterschiedliche Temperaturhübe, also Temperaturunterschiede 14, mit unterschiedlichen Maximaltemperaturen 34 auf. Auch die Dauer der jeweiligen Zyklen kann variieren. Die Anzahl 12 der Temperaturzyklen wird hier ebenfalls mit dem Bezugszeichen 12 versehen. Jeder Temperaturzyklus mit seiner Maximaltemperatur 34 und dem Temperaturunterschied 14 wird durch den sog. Rainflow-Count Algorithmus extrahier und als Belastungswert aufgenommen und in einer sogenannten Rainflow-Matrix 46 dargestellt. Hierbei werden verschiedene Einflussgrößen auf den jeweiligen Zyklus berücksichtigt und einer Gewichtung zugeführt. Diese Gewichtung erfolgt in einem Raffungsmodell, wobei hier das sogenannte Norris-Landzberg-Modell zum Einsatz kommt. Dieses bereits weiter oben beschriebene mathematische Modell verknüpft die Anzahl und Dauer der Zyklen mit deren Temperaturunterschiede 14, woraus auf der Auswerteeinheit 34 ein Gewichtungsfaktor 36 (in dem Modell mit AF bezeichnet) ermittelt wird. Dieser Gewichtungsfaktor 36, der für jeden einzelnen Temperaturzyklus ermittelt wird, wird mit diesem multipliziert und die so erhaltenen Werte werden aufaddiert. Hieraus resultiert der kumulative Belastungswert 26. Der kumulative Belastungswert 26 ist wiederum als prozentualer Anteil des Lebensdauererwartungswertes 16 zu sehen. In dem Beispiel gemäß Figur 3 liegt der kumulative Belastungswert 26 bei ca. 0,3, das heißt bei der so untersuchten Feldbaugruppe 20 sind nach dieser Berechnung 30 Prozent der Lebensdauererwartung abgelaufen. In dem Maßnahmenkatalog 30 auf der Auswerteeinheit 24 kann beispielsweise ein Grenzwert für den kumulativen Belastungswert festgelegt sein, bei dem die Maßnahme Austausch der Feldbaugruppe über die zweite Datenleitung 23 an die Überwachungseinheit 32 der Feldbaugruppen 20 weitergeleitet wird. Dieser Grenzwert kann z. B. bei 0,7 liegen. Ein weiteres Beispiel für einen Grenzwert wäre beispielsweise 0,35, bei dem eine Wartung der Feldbaugruppe 30 vorgenommen wird oder die Feldbaugruppe einem zweiten Lebenszyklus mit geringeren Feldlasten zugeführt wird. Ein weiterer Grenzwert könnte beispielsweise 0,6 sein, bei dem die Feldbaugruppe 20 je nach Einsatzfall und Einsatzsicherheitsbedürfnis ausgetauscht wird und einem Überholungsprozess und somit einem zweiten Einsatz zugeführt werden kann. Das Gleiche gilt auch im übertragenen Sinne auf die Neben-Feldbaugruppe 39 auf die die kumulativen Belastungswerte 26 entsprechende Erkenntnisse aus den Referenzbelastungswerten 10 übertragen werden können.

### Bezugszeichenliste

- 2: elektronische Baugruppe
- 4: Temperatursensor
- 6: Referenzbaugruppe
- 8: zyklische Temperaturbehandlung
- 10: Referenz-Belastungswert
- 12: Anzahl T-Zyklen
- 14: T-Unterschied
- 16: Lebensdauererwartungswert
- 18: Feld-Belastungswerte
- 20: Feldbaugruppen
- 22: Datenverbindung
- 23: zweite Datenverbindung
- 24: Auswerteeinheit
- 26: kumulativer Belastungswert
- 28: Maßnahmen
- 30: Maßnahmenkatalog
- 32: Überwachungseinheit Feldbaugruppe
- 34: Maximaltemperatur
- 36: Gewichtungsfaktor
- 38: Neben-Referenzbaugruppe
- 39: Neben-Feldbaugruppe
- 40: Messsensor
- 42: CPU
- 44: Feldanlage
- 46: Rainflow-Matrix

## Patentansprüche

1. Verfahren zur Überwachung einer elektronischen Baugruppe (2) mit einem Temperatursensor (4), umfassend folgende Schritte:
- Unterziehen mindestens einer Referenzbaugruppe (6) einer zyklischen Temperaturbehandlung (8), wobei Referenz-Belastungswerte (10) an Hand der Anzahl der Temperaturzyklen (12) und der Temperaturunterschiede (14) pro Temperaturzyklus bestimmt werden und hieraus ein Lebensdauererwartungswert (16) ermittelt wird,
- Messen von Feld-Belastungswerten (18) von im Einsatz befindlichen Feldbaugruppen (20),
- Übermitteln der Feld-Belastungswerte (18) über eine Datenverbindung (22) an eine elektronischen Auswerteeinheit (24),
- Ermitteln mittels eines Raffungsmodells eines kumulativer Belastungswertes (26),
- Ermitteln einer Maßnahme (28) durch die Auswerteeinheit (24) anhand eines Maßnahmenkatalogs (30) durch den Vergleich von Lebensdauererwartungswert (16) und kumulativer Belastungswert (26),
- Übermitteln der Maßnahme (28) über eine zweite Datenverbindung (23) an eine Überwachungseinheit (32) der Feldbaugruppen (20).

2. Verfahren nach Anspruch 1, **dadurch gekennzeichnet, dass** der Referenzbelastungswert (10) und der Feld-Belastungswert (18) aus folgenden Belastungskriterien, der Anzahl der Temperaturzyklen (12), der Temperaturunterschiede (14) pro Temperaturzyklus und/oder der Maximaltemperatur (34) pro Temperaturzyklus bestimmt wird.

3. Verfahren nach Anspruch 1 oder 2, **dadurch gekennzeichnet, dass** jedem Feld-Belastungswert (18) ein Gewichtungsfaktor zugeordnet wird und einzelne Feld-Belastungswerte gewichtet mit ihrem Gewichtungsfaktor (36) zum kumulativen Belastungswert (26) aufsummiert werden.

4. Verfahren nach Anspruch 3, **dadurch gekennzeichnet, dass** die Gewichtungsfaktoren (36) mit dem Norris-Landzberg-Modell (o.ä.) unter Einbeziehung der Referenz-Belastungswerte ermittelt werden.

5. Verfahren nach einem der vorhergehenden Ansprüche, **dadurch gekennzeichnet, dass** mehrere Referenzbaugruppen (6) der zyklischen Temperaturbehandlung (8) bis zum Ausfall mindestens einer Referenzbaugruppe (6) unterzogen werden.

6. Verfahren nach einem der vorhergehenden Ansprüche, **dadurch gekennzeichnet, dass** mit der Referenzbaugruppe (6) eine Neben-Referenzbaugruppe (38) der zyklischen Temperaturbehandlung 8 unterzogen wird und der Lebensdauererwartungswert (16) der Referenzbaugruppe (6) auf die Neben-Referenzbaugruppe (38) übertragen wird.

7. Verfahren nach einem der vorhergehenden Ansprüche, **dadurch gekennzeichnet, dass** der Lebensdauererwartungswert (16) der Feldbaugruppe (20) auf eine ihr zugeordneten Neben-Feldbaugruppe (39) übertragen wird.

8. Verfahren nach einem der vorhergehenden Ansprüche, **dadurch gekennzeichnet, dass** eine Maßnahme (28) des Maßnahmenkatalogs (30) der Austausch der Feldbaugruppe (6) und/oder der Neben-Feldbaugruppe (38) ist.

9. Verfahren nach einem der vorhergehenden Ansprüche, **dadurch gekennzeichnet, dass** die Temperaturmessung der Feldbaugruppe (20) mittels eines in die Feldbaugruppe (20) integrierten Messsensors (40) erfolgt.

10. Verfahren nach Anspruch 9, **dadurch gekennzeichnet, dass** die Temperaturmessung der Feldbaugruppe (20) mittels eines in die CPU (42) der Feldbaugruppe (20) integrierten Messsensors (40) erfolgt.

11. Verfahren nach einem der vorhergehenden Ansprüche, **dadurch gekennzeichnet, dass** das Übermitteln der Feld-Belastungswerte (18) über eine Datenverbindung (22) an eine von der Feldbaugruppe (20) räumlich getrennten elektronischen Auswerteeinheit (24) erfolgt.
